# EUROPEAN PATENT APPLICATION

(11) **EP 1 176 642 A2**
(43) Date of publication of application: **30.01.2002**
(21) Application number: 01202676.1
(22) Date of filing: 12.07.2001
(51) Int. Cl.: H01L 27/00, H01L 51/40

(54) **Method of making organic electroluminescent device using laser transfer**

(30) Priority: 25.07.2000 US 625423
(71) Applicant: EASTMAN KODAK COMPANY, Rochester, New York 14650 (US)
(72) Inventor: Tutt, Lee W., Rochester, New York 14650-2201 (US); Tang, Ching W., Rochester, New York 14650-2201 (US); Culver, Myron W., Rochester, New York 14650-2201 (US); Burberry, Mitchell S., Rochester, New York 14650-2201 (US)
(74) Representative: Lewandowsky, Klaus, Dipl.-Ing.

(57) **Abstract**

A method for making an organic electroluminescent display device having an array of pixels disposed on a display substrate providing an array of first electrodes on the display substrate; an unpatterned donor transfer substrate and a laser light absorbing layer over the donor transfer substrate and an organic emissive layer over the laser light absorbing layer; and positioning the donor transfer substrate in transfer relationship to the display substrate patterned with an array of first electrodes. The method also includes focusing and scanning a laser beam of sufficient power and desired spot size on the laser light absorbing layer on the donor substrate to effect the transfer of selected portions of the organic emissive layer from the donor substrate to designated areas corresponding to pixels on the display substrate in electrical connection with the first electrodes; and providing a second electrode over the transferred organic emissive portions on the display substrate.

## Description

The present invention relates to a method of making electroluminescent devices and, more particularly, to using laser transfer of organic emissive materials to produce pixels.

In color or full color organic electroluminescent (EL) displays having an array of colored pixels such as red, green, and blue color pixels (commonly referred to as RGB pixels) precision patterning of the color producing organic EL media are required to produce the RGB pixels. The basic EL device has in common an anode, a cathode, and an organic EL medium sandwiched between the anode and the cathode. The organic EL medium may consist of one or more layers of organic thin films, where one of the layers is primarily responsible for light generation or electroluminescence. This particular layer is generally referred to as the emissive layer of the organic EL medium. Other organic layers present in the organic EL medium may provide electronic transport functions primarily and are referred to as either the hole transport layer (for hole transport) or electronic transport layer (for electron transport). In forming the RGB pixels in a full color organic EL display panel, it is necessary to devise a method to precisely pattern the emissive layer of the organic EL medium or the entire organic EL medium.

Typically, electroluminescent pixels are formed on the display by shadow masking techniques such as shown in US-A-5,742,129. Although this has been effective, it has several drawbacks. It has been difficult to achieve high resolution of pixel sizes using shadow masking. Moreover, there are problems of alignment between the substrate and the shadow mask, and care must be taken that pixels are formed in the appropriate locations. When it is desirable to increase the substrate size, it is difficult to manipulate the shadow mask to form appropriately positioned pixels.

Donor materials have been known for many years for the purpose of laser thermal dye transfer of images as taught in US-A-4,772,582 and references therein. The process uses donor sheets to transfer different colors using a laser beam to heat up and thermally transfer dyes from the donor to the receiver. This method is used for high quality images but does not teach the transfer of EL materials.

A suitable method for patterning high-resolution organic EL displays has been disclosed in US-A-5,851,709. This method is comprised of the following sequences of steps: 1) providing a substrate having opposing first and second surfaces; 2) forming a light transmissive heat insulating layer over the first surface of the substrate; 3) forming a light absorbing layer over the heat insulating layer; 4) providing the substrate with an array of openings extending from the second surface to the heat insulating layer; 5) providing a transferable color forming organic donor layer formed on the light absorbing layer; 6) precision aligning the donor substrate with the display substrate in an oriented relationship between the openings in the substrate and the corresponding color pixels on the device; and 7) employing a source of radiation for producing sufficient heat at the light absorbing layer over the openings to cause the transfer of the organic layer on the donor substrate to the display substrate. A problem with the Grande and others approach is that patterning of an array of openings on the donor substrate is required. Another problem is that the requirement for precision mechanical alignment between the donor substrate and the display substrate. A further problem is that the donor pattern is fixed and cannot be changed readily.

It is an object of the present invention to provide a method for patterning the organic EL medium without the limitations imposed by the conventional photolithographic or shadow mask methods.

It is another object of the present invention to provide a method for patterning high-resolution, full color, organic EL displays.

It is another object of the invention to provide a method for patterning high-resolution color EL displays without the limitation of mechanical precision alignment and allowing for dynamic alignment and simple pattern changes.

These objects are achieved by a method for making an organic electroluminescent display device having an array of pixels disposed on a display substrate, comprising the steps of:
a) providing an array of first electrodes on the display substrate;
b) providing an unpatterned donor transfer substrate and a laser light absorbing layer over the donor transfer substrate and an organic emissive layer over the laser light absorbing layer;
c) positioning the donor transfer substrate in a transfer relationship to the display substrate patterned with an array of first electrodes;
d) focusing and scanning a laser beam of sufficient power and desired spot size on the laser light absorbing layer on the donor substrate to effect the transfer of selected portions of the organic emissive layer from the donor substrate to designated areas corresponding to pixels on the display substrate in electrical connection with the first electrodes; and
e) providing a second electrode over the transferred organic emissive portions on the display substrate.

### ADVANTAGES

The present invention provides a method of making full color, organic EL displays. An advantage of this method is that, by printing with a scanning laser beam, fine precision patterning of colored pixels can be achieved, enabling the production of high resolution displays. Another advantage of this method is that precision manipulation of the display substrate with respect to either an aperture mask or a donor substrate is unnecessary, thus registration errors or distortion caused mask misalignment and mismatch in thermal expansion coefficients are reduced and the fabrication process for high-resolution organic EL displays is much simplified and fast. A further advantage of this method is that the deposition and patterning procedure can be carried out with compact equipment and it does not require a high vacuum environment.
FIG. 1 shows a schematic of an apparatus which is useful for transferring portions of a light emissive layer onto a display transfer from a donor transfer substrate;
FIG. 2 depicts, in more detail, the display substrate and the donor transfer substrate shown in FIG. 1; and
FIG. 3 shows, in cross section, a schematic of a colored organic electroluminescent display device.

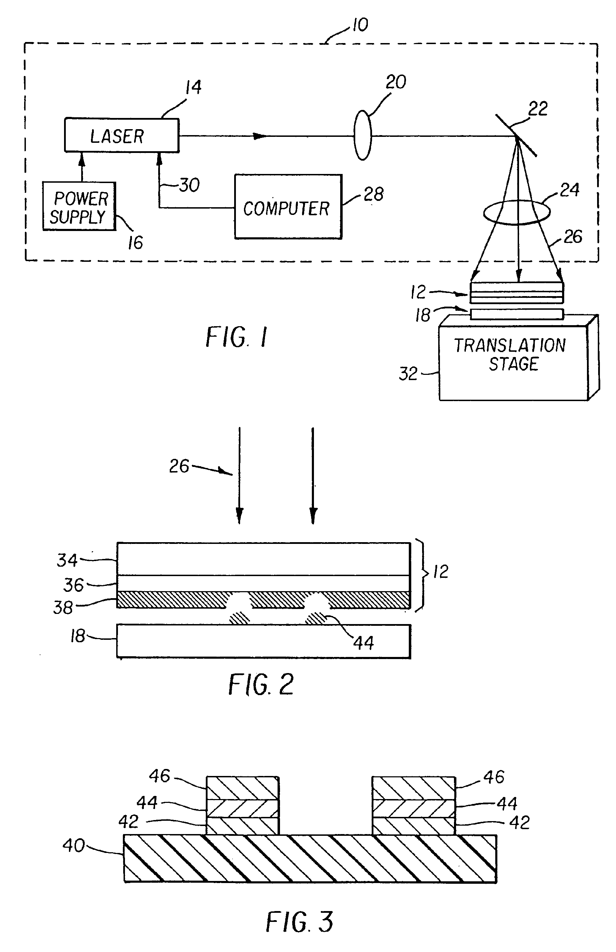

Turning now to FIG. 1, there is shown a laser printing apparatus 10 for transferring portions of a donor composite 12 onto a display substrate substrate in accordance to the present invention. The laser 14 can be a diode laser or any other high power laser which produces a laser beam 26. The laser 14 is driven by an appropriate power supply 16. In order to scan the laser beam to provide relative movement between the laser beam and the donor substrate, a galvanometer 22 that includes a moveable mirror scans the beam through an f-theta lens 24 to form a line. A donor composite 12 and the display composite 18 are transported perpendicular to the line by a translation stage 32 allowing the full area to be scanned. The intensity of the beam at any point in the scan is controlled by through the laser power control line 30 by the computer 28.

The f-theta lens 24 focuses the laser beam and the galvanometer 16 scans the laser beam. The laser beam, in order to transfer portions of the light emission layer, must have sufficient power. The spot size caused by the f-theta lens 24 dictates the area of the light emissive layer that will be transferred. The arrangement is such that, when the laser beam has sufficient power, the spot size causes a portion of the light emissive layer to be selectively transferred from the donor substrate to designated areas corresponding to pixels on the display substrate in electrical connection with first electrodes, as will be described hereinafter.

In a preferred embodiment, the beam is continuously scanned by the galvanometer 22 across the unpatterned donor substrate 34 while the laser power is modulated by the computer 28. The modulation of laser power incident on the donor composite 12 causes transfer of the donor in selectable amounts in selected regions of the scan. The translation stage is continuously translating the display composite 18 and donor composite 12 so that the each scan covers new donor regions.

As shown in FIGS. 1 and 2, the donor composite 12, including the unpatterned donor substrate 34, is positioned in transfer relationship to the display substrate 40 patterned with the array of first electrodes 42. A laser thermal dye (LDT) transfer process is used in accordance with the present invention for selectively transferring portions of the organic emissive layer 38 onto the display substrate 40. These portions will hereinafter be called the transferred organic emissive layer 44. The donor composite 12 used in the transfer process includes a transparent sheet coated with a laser absorbing material. For examples of donor composites, which can use a organic emissive layer 38, see US-A-4,772,582. At least one laser beam 26 is needed for tranferring portions of the organic emissive layer 38. The laser beam should be focused and scanned across the donor composite 12. The laser beam 26 is shown as two spaced arrows. For convenience of illustration, it will be understood that the laser beam 26 has actually been moved between two different positions where it is turned on for transferring portions of the emissive layer 38. The laser beam 26 should be of sufficient power and desired spot size so that when it impinges on a light absorbing layer an appropriate area and amount of organic emissive material is transferred to the display substrate. The laser light absorbing layer 36 is formed between the donor substrate 34 and the organic emissive layer 38. The laser beam 26 causes the transfer of selected portions of the organic emissive layer 38 from the donor composite 12 to designated areas corresponding to pixels on the display substrate 40. These selected portions are in electrical connection with the first electrodes. In accordance with the present invention, different colored organic emissive layers can be provided with different donor composites 12.

In order to form a colored array, the above transfer process must be repeated for transferring different portions of different colored organic emissive layers from different composites to the display substrate 40.

After the transfer of portions of one or more colored organic emissive layers, a second electrode 46 is provided over selected transferred portions of the colored organic emissive portions on the display substrate 40. The second electrode can either be an array of different electrodes or a single conductive layer.

A laser dye transfer process can be used for producing color EL devices. In contrast to imaging applications, the donor materials are chosen to produce the EL emissive layer in the EL device. A suitable donor material contains a mixture of a laser absorbing material and an electroluminescent material and is coated on a donor substrate. Similar to the imaging applications, the LDT process is used to effect the transfer of the electroluminescent material from the donor substrate to a display substrate 40 that is the color EL display panel. A full color EL display can thus be achieved by LDT printing using a sequence of red, green, and blue donor materials coated on separate donor substrates containing, respectively, red, green, and blue electroluminescent materials.

Organic emissive materials useful in layer 38 are well known to include one or more host materials and light-emissive materials such as fluorescent dyes. The fluorescent dyes can be doped into the host materials as is well known to those skilled in the art. Examples of light-emissive organic EL host materials and of fluorescent dyes which are useful as a donor layer for selective transfer onto an organic EL display device to form red, green, or blue light emitting subpixels thereon include the following: 2-methyl-8-hydroquinoline aluminum; 8-hydroquinoline aluminum; coumarin-6; 4-(dicyanoethylene)-2-methyl-6-(p-dimethylamino styryl)-4-H-pyran; quinacridone fluorescent dyes; and perylene fluorescent dyes. Other useful organic EL materials, including light emitting organic host materials and fluorescent dyes used as dopants or as guests in such hosts, are disclosed in commonly assigned US-A-4,769,292, US-A-5,405,709, US-A-5,294,870 and US-A-5,683,823, the disclosures of which are included herein by reference.

Preferably, each of the red, green, and blue light-emissive organic EL materials of the respective donor layer would be a single organic material. However, as will be apparent from the above referenced US-A-4,769,292, US-A-5,405,709, US-A-5,294,870 and US-A-5,683,823, red, green, and blue light-emissive layers on respective subpixels of the EL display devices are frequently formed from a light-emissive organic EL host material having one or more fluorescent dyes incorporated in the light-emissive layer in order to achieve a desired brightness of light emission and a desired color or hue of the emitted light from the EL display device.

A donor material is made as shown in FIG. 2 which contains an unpatterned donor substrate 34 , a laser light absorbing layer 36, and an organic emissive layer 38. The unpatterned donor substrate 34 can be made of a transparent material such as glass or a polymer. Optionally, a fluorescent dye material may be co-mingled with the organic emissive layer 38. The laser light absorbing material and the organic emissive material may be coextensive or in a layered structure. The layered structure can be used to decrease contamination due to transfer of the light absorbing material.

The donor substrate may be an inorganic compound such as glass or may be an organic polymer such as polyimide, polycarbonate, or polyester. The substrate may be any thickness but is preferred to be in the range of from about 10 microns to 1000 microns.

The laser light absorbing material may be a dye such as the dyes specified in US-A-5,578,416 or a pigment such as carbon. The light absorbing layer may be a metal such as nickel, titanium, etc, or a layered antireflection stack. The main criteria is that the light absorbing layer absorbs at the wavelength of the laser with an optical density high enough to absorb most of the laser light, thereby sufficient heat is produced to cause the organic emission layer to transfer. This transfer is well known to depend on the laser fluence, spot size, beam overlap and other factors. Generally, the optical density of the light absorbing layer should be at least 0.1 (∼20% of the light is absorbed).

The laser 14 can be an infrared solid state laser, a Neodymium YAG laser or any other laser providing a sufficient power to effect transfer of the donor material. The power necessary will be dependent on the match between the absorption of the light absorbing layer and the wavelength of the laser. The beam shape may be oval to allow small lines to be written while using low cost multimode lasers.

FIG. 3 shows the completed colored organic electroluminescent display. The display substrate 40 has an array or a plurality of spaced first electrodes 42 deposited on top of the substrate. Onto this the laser thermal transferred organic emissive layer 44 is placed. The second electrode 46 is then applied. In the figure, different stacks can have different organic emissive layers to allow different colors. One of the electrodes must be transparent to allow viewing of the emission. In the preferred embodiment the substrate 40 and the first array of electrodes 42 are conductive and can be made of indium tin oxide or other conductors that are transparent. Of course, viewing in this case is through the substrate. The substrate 40 is nonconductive and transparent and conveniently can be made of glass.

### Example 1

A donor composite was formed by the vacuum deposition of an absorption layer of 2000-4000 angstroms of silver/indium tin oxide on a 5 mil polyimide substrate. Onto this was vacuum deposited a 1500 angstroms thick layer of of 8-hydroxyquinoline (ALQ) and 1 % 4-(dicyanomethylene)-2-t-butyl-6-(1,1,7,7,-tetramethyl julolidyl-9-enyl)- 1H-pyran (DCJTB).

A clean glass substrate was vacuum deposited to pattern a 400 to 800 angstrom electrodes. A 1500 angstrom 4,4'-bis[N-(1-naphthyl)-N-phenylamino]-bi-phenyl (NPB) was then vacuum deposited. A donor composite as previously described was placed in contact with the NPB layer.

Laser transfer was effected from the donor composite to the display substrate 40 by irradiation of the donor composite through the substrate with an infrared beam. The beam size was approximately 16 microns by 80 microns to the 1/e² point. The dwell time was 27 microseconds with a power density of ∼500 mw.

Onto the transferred light emissive material from the donor composite, conductive material was vacuum deposited 375 angstroms ALQ followed by 200 angstroms of silver and 2000 angstroms of magnesium.

Upon the application of 9 volts an orange emission was seen to occur. A control sample glowed green indicating the absence of the fluorescent dye where no laser transfer had occurred.

## Claims

1. A method for making an organic electroluminescent display device having an array of pixels disposed on a display substrate, comprising the steps of:
a) providing an array of first electrodes on the display substrate;
b) providing an unpatterned donor transfer substrate and a laser light absorbing layer over the donor transfer substrate and an organic emissive layer over the laser light absorbing layer;
c) positioning the donor transfer substrate in transfer relationship to the display substrate patterned with an array of first electrodes;
d) focusing and scanning a laser beam of sufficient power and desired spot size on the laser light absorbing layer on the donor substrate to effect the transfer of selected portions of the organic emissive layer from the donor substrate to designated areas corresponding to pixels on the display substrate in electrical connection with the first electrodes; and
e) providing a second electrode over the transferred organic emissive portions on the display substrate.

2. A method for making a color organic electroluminescent display device having an array of multi-color pixels disposed on a display substrate, comprising the steps of:
a) providing an array of first electrodes on the display substrate;
b) providing an unpatterned donor transfer substrate and a laser light absorbing layer over the donor transfer substrate and a first colored organic emissive layer over the laser light absorbing layer;
c) positioning the donor transfer substrate in transfer relationship to the display substrate patterned with an array of first electrodes;
d) focusing and scanning a laser beam of sufficient power and desired spot size on the laser light absorbing layer on the donor substrate to effect the transfer of selected portions of the organic emissive layer from the donor substrate to designated areas corresponding to pixels on the display substrate in electrical connection with the first electrodes;
e) repeating steps b) to d) for transferring different portions of different colored organic emissive layers to the display substrate; and
f) providing a second electrode over selected transferred portions of the different colored organic emissive portions on the display substrate.

3. The method of claim 2 wherein the colors of the different colored portions are red, green, and blue.

4. The method of claim 3 wherein the organic emissive layer includes a host material and at least one color dopant for each color.

5. The method of claim 4 wherein the blue color is provided by a blue dopant.

6. The method of claim 3 wherein the green color is provided by a green dopant.

7. The method of claim 3 wherein the red color is provided by a red dopant.

8. A device made in accordance with the method of claim 1.

9. A device made in accordance with the method of claim 2.
